# FASCICULE DE BREVET EUROPEEN

(11) **EP 3 092 647 B1**
(45) Date de publication et mention de la délivrance du brevet: **10.04.2019**
(21) Numéro de dépôt: 15702382.1
(22) Date de dépôt: 07.01.2015
(51) Int. Cl.: G11C 11/419, G11C 11/00, G11C 11/16, G11C 14/00

(54) **MEMOIRE MUNIE DE CELLULES DE MEMOIRE VOLATILE ET NON VOLATILE ASSOCIEES**
SPEICHER MIT ZUGEHÖRIGEN FLÜCHTIGEN UND NICHTFLÜCHTIGEN SPEICHERZELLEN
MEMORY PROVIDED WITH ASSOCIATED VOLATILE AND NON-VOLATILE MEMORY CELLS

(30) Priorité: 10.01.2014 FR 1450196
(43) Date de publication de la demande: 16.11.2016
(73) Titulaire: Commissariat à l'Energie Atomique et aux Energies Alternatives, 75015 Paris (FR); Centre National de la Recherche Scientifique, 75794 Paris Cedex 16 (FR)
(72) Inventeur: JAVERLIAC, Virgile, F-38100 Grenoble (FR); LAYER, Christophe, F-38000 Grenoble (FR)
(74) Mandataire: Cabinet Beaumont
(86) Numéro de dépôt international: PCT/EP2015/050177
(87) Numéro de publication internationale: WO 2015/104297

(56) Documents cités:
- DE-A1-102005 001 667
- DE-A1-102005 001 667
- FR-A1- 2 970 590
- US-A- 4 716 552
- US-A- 4 716 552
- US-A1- 2011 122 709
- US-A1- 2013 135 918

## Description

La présente demande de brevet revendique la priorité de la demande de brevet français FR14/50196 qui sera considérée comme faisant partie intégrante de la présente description.

### Domaine

La présente description concerne le domaine des réseaux de mémoire, et en particulier un réseau de mémoire combinant une mémorisation de données volatiles et de données non volatiles.

### Arrière-plan

Il a déjà été proposé d'utiliser des éléments résistifs programmables dans des cellules mémoires pour assurer une mémorisation de données non volatiles. De tels éléments résistifs sont programmables pour prendre l'un de deux états résistifs différents. L'état résistif programmé est conservé même lorsqu'une tension d'alimentation de la cellule mémoire est déconnectée, et ainsi des données peuvent être mémorisées par de tels éléments de façon non volatile.

Divers types d'éléments résistifs ont été proposés, dont certains sont capables d'être programmés par la direction d'un courant qu'on fait passer dans l'élément résistif. Un exemple d'un tel élément résistif programmable par un courant est un élément STT (à couple de transfert de spin), qui est basé sur des jonctions tunnel magnétiques (MTJ).

Une difficulté dans l'utilisation d'éléments résistifs pour la mémorisation de données est que les opérations de lecture et d'écriture ont tendance à être relativement lentes, ce qui entraine un temps d'accès élevé par rapport à une mémoire volatile standard comme une mémoire SRAM (mémoire statique à accès aléatoire). Pour résoudre cette difficulté, on a proposé de prévoir, dans chaque cellule mémoire, un circuit pour programmer l'état de l'élément résistif et pour lire, amplifier et mémoriser un état résistif programmé. Toutefois, bien qu'une telle solution conduise à une amélioration des temps d'accès, la surface utilisée par chaque cellule mémoire et la consommation d'énergie ont tendance à être élevées.

On a donc besoin dans la technique d'un réseau de mémoire non volatile ayant des temps d'accès relativement faibles et/ou une surface réduite par rapport à des mémoires non volatiles existantes.

La demande de brevet allemand publiée sous le numéro DE1020050016677 concerne une cellule mémoire non volatile.

### Résumé

Un objet de modes de réalisation de la présente description est de résoudre au moins partiellement un ou plusieurs besoins de l'art antérieur.
Selon un aspect, on prévoit une matrice mémoire comprenant : une pluralité de cellules de mémoire volatile comprenant chacune une bascule ; une pluralité de cellules de mémoire non volatile comprenant chacune au moins un élément résistif programmable par la direction d'un courant qu'on fait passer dans celui-ci pour prendre l'un d'au moins deux états résistifs, chacune des cellules de mémoire non volatile étant associée à l'une correspondante des cellules de mémoire volatile ; et un circuit de lecture/écriture couplé à chacune des cellules de mémoire volatile et non volatile par l'intermédiaire d'une ou plusieurs paires de lignes de bit, le circuit de lecture/écriture comportant un comparateur comportant des première et deuxième entrées, et adapté à lire un premier bit de donnée mémorisé par une première des cellules de mémoire volatile et à lire un deuxième bit de donnée mémorisé par une deuxième des cellules de mémoire non volatile, le circuit de lecture/écriture comprenant en outre : au moins un multiplexeur adapté à coupler les première et deuxième entrées du comparateur à des noeuds de mémorisation complémentaires de la première cellule de mémoire volatile pour lire le premier bit de donnée, et à coupler les première et deuxième entrées du comparateur à des sorties d'un amplificateur adapté à détecter l'état résistif programmé de la deuxième cellule de mémoire non volatile..

Selon un mode de réalisation, la matrice mémoire comprend en outre un circuit de lecture/écriture comportant un comparateur adapté à lire un premier bit de donnée mémorisé par une première des cellules de mémoire volatile et à lire un deuxième bit de donnée mémorisé par une deuxième des cellules de mémoire non volatile.

Selon un mode de réalisation, le circuit de lecture/écriture est adapté à réaliser au moins l'une des opérations suivantes : lire un premier bit de donnée mémorisé par une première des cellules de mémoire volatile et programmer, sur la base du premier bit de donnée, l'état résistif d'une première des cellules de mémoire non volatile associée à la première cellule de mémoire volatile ; et lire dans une deuxième des cellules de mémoire non volatile, un état résistif programmé représentant un deuxième bit de donnée et écrire le deuxième bit de donnée dans une deuxième des cellules de mémoire volatile associée à la deuxième cellule de mémoire non volatile.

Selon un mode de réalisation, le circuit de lecture/écriture comprend en outre : un circuit d'écriture adapté à écrire un bit de donnée dans une première des cellules de mémoire volatile en appliquant une tension entre des noeuds de mémorisation complémentaires de la première cellule de mémoire volatile et à programmer un état résistif d'une première des cellules de mémoire non volatile en faisant passer un courant dans l'élément résistif de la première cellule de mémoire non volatile.

Selon un mode de réalisation, la matrice mémoire comprend en outre une pluralité de lignes de sélection, et chacune des cellules de mémoire volatile et sa cellule de mémoire non volatile associée est couplée à une même ligne de sélection de la matrice mémoire.

Selon un mode de réalisation, chacune des cellules de mémoire volatile et sa cellule de mémoire non volatile associée sont couplées à une même paire de lignes de bit.

Selon un mode de réalisation, chacune des cellules de mémoire volatile est couplée à une première paire de lignes de bit et chacune des cellules de mémoire non volatile est couplée à une deuxième paire de lignes de bit.

Selon un mode de réalisation, chacune des cellules de mémoire volatile est couplée à un rail de tension d'alimentation couplé par l'intermédiaire d'un commutateur à un niveau de tension d'alimentation.

Selon un mode de réalisation, chacune des cellules de mémoire non volatile comprend un seul élément résistif couplé en série avec un premier transistor entre une paire de lignes de bit.

Selon un mode de réalisation, chacune des cellules de mémoire non volatile comprend : un premier élément résistif couplé en série avec un premier transistor entre une première ligne de bit et une première tension d'alimentation ; et un deuxième élément résistif couplé en série avec un deuxième transistor entre une deuxième ligne de bit et la première tension d'alimentation.

Selon un mode de réalisation, ledit au moins un élément résistif de chacune des cellules de mémoire non volatile est de l'un des types suivants : un élément à couple de transfert de spin ayant une anisotropie dans le plan ; un élément à couple de transfert de spin ayant une anisotropie perpendiculaire au plan ; et un élément à oxydoréduction.

Selon un autre aspect, on prévoit un procédé de sauvegarde de données dans la matrice mémoire susmentionnée, le procédé comprenant : lire un premier bit de donnée mémorisé par une première des cellules de mémoire volatile ; et programmer l'état résistif d'une première des cellules de mémoire non volatile associée à la première cellule de mémoire volatile sur la base du premier bit de données.

Selon un autre aspect, on prévoit un procédé de restauration de données dans la matrice mémoire susmentionnée, le procédé comprenant : lire dans une deuxième des cellules de mémoire non volatile un état résistif programmé représentant un deuxième bit de données ; et écrire le deuxième bit de données dans une deuxième des cellules de mémoire volatile associée à la deuxième cellule de mémoire non volatile.

### Brève description des dessins

Les caractéristiques et avantages susmentionnés, et d'autres, apparaîtront clairement à lecture de la description détaillée suivante de modes de réalisation, donnés à titre d'illustration et non de limitation, en faisant référence aux dessins joints dans lesquels :
la figure 1 illustre schématiquement un exemple de bascule non volatile ;
la figure 2 illustre schématiquement une partie d'une matrice de mémoire non volatile/volatile selon un exemple de réalisation ;
la figure 3 illustre schématiquement une cellule de mémoire non volatile selon un exemple de réalisation ;
la figure 4 illustre schématiquement une partie d'une mémoire non volatile/volatile selon un autre exemple de réalisation ;
les figures 5A à 5F illustrent schématiquement des matrices de mémoire non volatile/volatile selon des exemples de réalisation ;
la figure 6 illustre schématiquement une cellule de mémoire volatile plus en détail selon un exemple de réalisation ;
la figure 7A illustre schématiquement une matrice de mémoire non volatile/volatile selon un exemple de réalisation de la présente description ;
la figure 7B illustre schématiquement un multiplexeur de colonne de la matrice mémoire de la figure 7A plus en détail selon un exemple de réalisation ; et
la figure 8 est un chronogramme représentant des exemples de signaux dans la matrice mémoire de la figure 7A selon un exemple de réalisation.

### Description détaillée

Dans la description suivante, le terme "connecté" est utilisé pour faire référence à une connexion directe entre un élément et un autre, tandis que le terme "couplé" implique que la connexion entre les deux éléments peut être directe, ou se faire par l'intermédiaire d'un élément intermédiaire, comme un transistor, une résistance ou un autre composant.

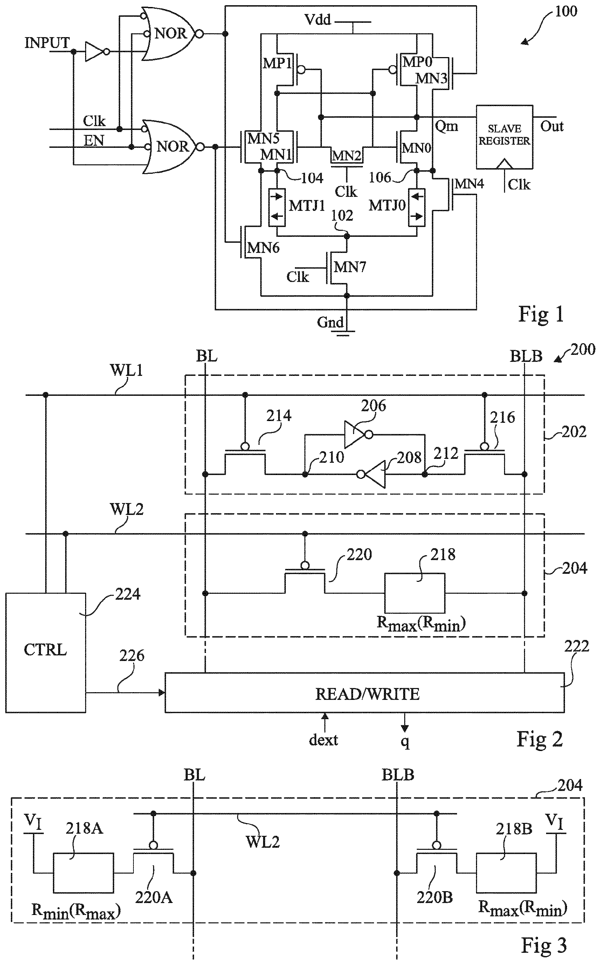

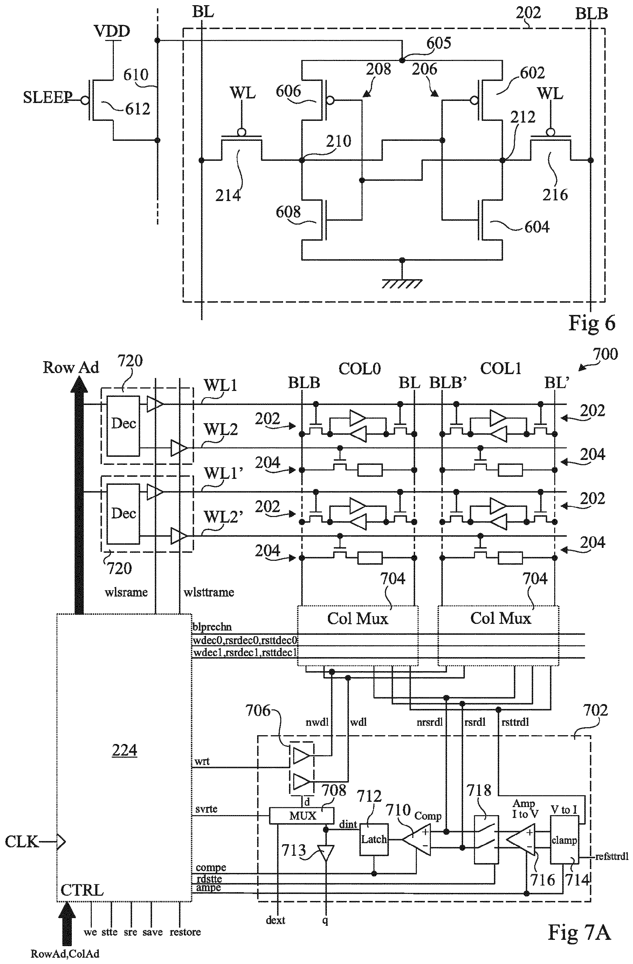

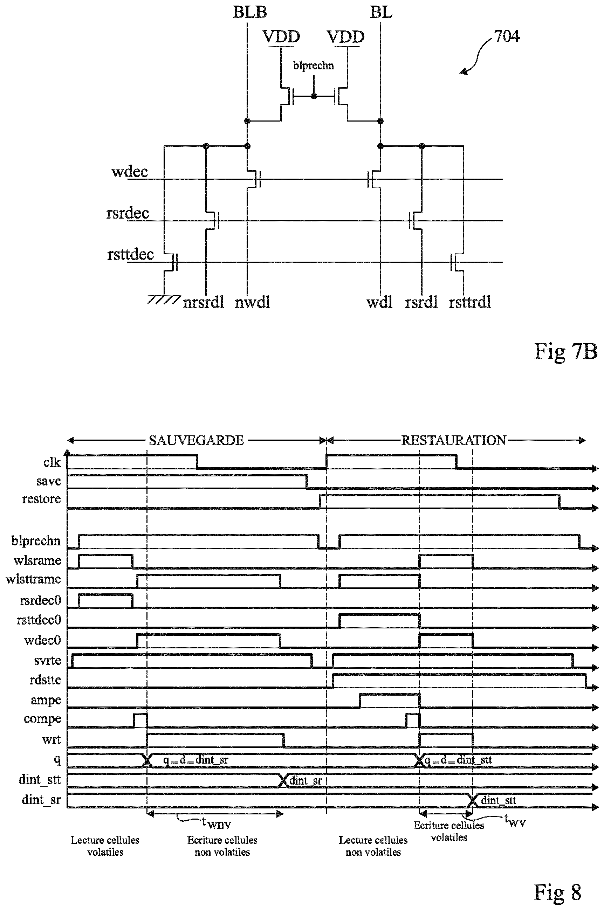

La figure 1 reproduit sensiblement la figure 7 de la publication intitulée " Spin-MTJ based Non-Volatile Flip-Flop", Weisheng Zhao et al., Proceedings of the 7th IEEE International Conférence on Nanotechnology, August 2-5, 2007, Hong-Kong.

La bascule 100 représentée en figure 1 comprend un registre maître et un registre esclave (SLAVE REGISTER). Le registre maître comprend des dispositifs à jonction tunnel magnétique MTJ1 et MTJ0, programmables par la direction d'un courant qu'on fait passer dans ceux-ci. Le dispositif MTJ1 est connecté entre un noeud intermédiaire 104 et un noeud d'interconnexion 102. Le dispositif MTJ0 est connecté entre un noeud intermédiaire 106 et le noeud d'interconnexion 102. Le noeud d'interconnexion 102 connecte entre eux les dispositifs MTJ MTJ0 et MTJ1. Le noeud intermédiaire 104 est en outre couplé à une tension d'alimentation Vdd par l'intermédiaire d'une paire de transistors MN1 et MP1 couplés en série et formant un premier inverseur. Le noeud intermédiaire 106 est en outre couplé à la tension d'alimentation Vdd par l'intermédiaire d'une paire de transistors MP0 et MN0 couplés en série et formant un deuxième inverseur. Les premier et deuxième inverseurs sont couplés entres eux de façon croisée, et la sortie du deuxième inverseur est connectée au registre esclave. Un transistor MN2 est couplé entre les noeuds de grille des transistors MN1 et MN0.

Un transistor MN5 est couplé entre le noeud intermédiaire 104 et la tension d'alimentation Vdd, et un transistor MN6 est couplé entre le noeud intermédiaire 104 et la masse. En outre, un transistor MN3 est couplé entre le noeud intermédiaire 106 et la tension d'alimentation Vdd, et un transistor MN4 est couplé entre le noeud intermédiaire 106 et la masse. Un transistor MN7 est couplé entre le noeud intermédiaire 102 et la masse. Les transistors MN3 à MN6 permettent le passage d'un courant à travers les éléments résistifs MTJ1 et MTJ0 dans une direction ou l'autre afin de programmer les états résistifs des dispositifs MTJ. Pendant cette phase de programmation, le transistor MN7 est utilisé pour déconnecter le noeud 102 de la masse. Deux portes du type NON OU et un inverseur sur le côté gauche de la figure 1, qui sont contrôlés par un signal d'entrée INPUT, un signal d'horloge Clk et un signal de d'activation EN, génèrent des signaux pour contrôler les transistors MN3 à MN6. Lorsque le transistor MN7 est activé, les transistors MP0, MP1, MN0 et MN1 forment un amplificateur de détection pour lire les états des éléments MTJ0 et MTJ1.

La cellule mémoire formant le registre maître de la figure 1 n'est pas adaptée à une utilisation dans une matrice mémoire au vu de son nombre relativement élevé de transistors. En outre, les transistors constituant l'amplificateur de détection sont relativement gros, puisqu'ils doivent être capables de faire passer un courant suffisant pour permettre aux états résistifs des éléments MTJ0 et MTJ1 d'être détectés.

La figure 2 illustre schématiquement un circuit 200 associé à une colonne d'une matrice mémoire combinée non volatile/volatile selon un exemple de réalisation de la présente description.

Le circuit 200 comprend une cellule de mémoire volatile 202, et une cellule de mémoire non volatile 204 associée à la cellule de mémoire volatile 202. Comme cela apparaitra clairement dans la suite, les cellules de mémoire volatile et non volatile sont associées entres elles en ce que, au moins une certaine partie du temps, la cellule de mémoire non volatile mémorise une sauvegarde d'un bit de données maintenu par la cellule de mémoire volatile, et peut être utilisée pour restaurer ce bit de données dans la cellule de mémoire volatile. Dans l'exemple de la figure 2 les cellules mémoires 202, 204 sont couplées entre une même paire de lignes de bit BL, BLB.

Bien que la figure 2 illustre une seule cellule de mémoire volatile et une seule cellule de mémoire non volatile, la colonne peut comprendre un nombre quelconque de cellules volatiles et de cellules non volatiles associées couplées entre les lignes de bit BL et BLB. En outre, bien qu'une seule colonne soit illustrée en figure 2, la matrice mémoire peut comprendre un nombre quelconque de colonnes du type représenté en figure 2, chacune ayant un circuit de lecture/écriture correspondant.

La cellule de mémoire volatile 202 est par exemple une cellule SRAM (mémoire statique à accès aléatoire), comprenant une bascule formée par deux inverseurs 206, 208 couplés de façon croisée entre des noeuds de mémorisation 210, 212. Un transistor 214, qui est par exemple un transistor PMOS, couple le noeud de mémorisation 210 à la ligne bit BL. Un transistor 216 qui est aussi par exemple un transistor PMOS, couple le noeud de mémorisation 212 à la ligne de bit BLB. Les transistors 214 et 216 sont par exemple contrôlés par une ligne de sélection de rangée WL1 de la matrice mémoire.

La cellule de mémoire non volatile 204 comprend par exemple un élément résistif programmable 218 couplé en série avec un transistor 220, qui est par exemple un transistor PMOS, entre les lignes de bit BL et BL1. Le transistor 220 est par exemple contrôlé par une ligne de sélection de rangée WL2 de la matrice mémoire.

L'élément résistif 218 est par exemple un élément à commutation de résistance d'un type quelconque pour lequel la résistance est programmable par la direction d'un courant qu'on fait passer dedans. L'élément résistif 218 est par exemple un élément STT (transfert de couple de spin) ayant une anisotropie dans le plan ou perpendiculaire au plan, comme cela est décrit plus en détail dans la publication intitulée "Magnonic spin-transfer torque MRAM with low power, high speed, and error-free switching", N.Mojumder et al., IEDM Tech. Digest (2010), and in the publication entitled "Electric toggling of magnets", E. Tsymbal, Natural Materials Vol 11, January 2012. À titre de variante, les éléments résistifs pourraient être ceux utilisés dans des mémoires à commutation de résistance du type RAM RedOx (RAM à oxydoréduction), qui sont par exemple décrites plus en détail dans la publication intitulée "Redox-Based Resistive Switching Memories - Nanoionic Mechanisms, Prospects and Challenges", Rainer Waser et al., Advanced Materials 2009, 21, pages 2632 to 2663.

Quel que soit le type d'élément résistif, un bit de donnée est par exemple mémorisé de façon non volatile en programmant l'élément de façon à avoir soit une résistance relativement élevée (Rₘₐₓ) soit une résistance relativement faible (Rₘᵢₙ). L'élément résistif 218 par exemple a seulement deux états résistifs correspondant aux résistances haute et basse Rₘₐₓ et Rₘᵢₙ, mais les valeurs exactes de Rₘᵢₙ et Rₘₐₓ peuvent varier en fonction de conditions comme le processus de fabrication, les matériaux, les variations de température, etc. L'élément résistif 218 est par exemple choisi de telle sorte que la résistance Rₘₐₓ soit toujours notablement supérieure à Rₘᵢₙ, par exemple supérieure d'au moins 20 pourcent. En général, le rapport entre la résistance Rₘₐₓ et la résistance Rₘᵢₙ est par exemple compris entre 1,2 et 10000. Rₘᵢₙ est par exemple de l'ordre de 2 kilo-ohms ou moins, et Rₘₐₓ est par exemple de l'ordre de 6 kilo-ohms ou plus, bien que de nombreuses autres valeurs soient possibles.

Les lignes de bit BL et BLB sont couplées à un circuit de lecture/écriture (READ/WRITE) 222. Un circuit de commande 224 fournit des signaux de commande sur une ligne 226 vers le circuit de lecture/écriture 222, et aux lignes de sélection WL1 et WL2. Le circuit de lecture/écriture 222 est capable de lire un bit de donnée dans la cellule de mémoire volatile 202, par exemple en pré-chargeant les lignes de bit BL et BLB avec une tension élevée, et en détectant une chute de tension sur l'un ou l'autre des bits lorsque le signal WL1 est activé par le circuit de commande 224. Le circuit de lecture/écriture 222 est aussi capable de lire un bit de données dans la cellule de mémoire non volatile 204, par exemple en appliquant une tension entre les lignes de bit BL, BLB pendant que le signal WL2 est activé par le circuit de commande 224, afin de générer un courant dans l'élément résistif 218. Le niveau de ce courant est par exemple comparé à un courant de référence afin de déterminer l'état résistif programmé de l'élément 218. La donnée lue dans la cellule de mémoire non volatile 202 ou la cellule de mémoire volatile 204 peut être fournie sous la forme d'un signal q au niveau d'une sortie du circuit de lecture/écriture 222, et/ou écrite dans l'une des cellules de mémoire volatile ou non volatile pendant une phase de sauvegarde ou de restauration, comme cela va être expliqué plus en détail.

Le circuit de lecture/écriture 222 est capable d'écrire un bit de donnée dans la cellule de mémoire non volatile 204 par l'intermédiaire des lignes de bit BL et BLB. Cette donnée peut être une donnée externe dext fournie au circuit de lecture/écriture 222 à partir d'un circuit externe, ou une donnée interne lue dans les autres cellules mémoires, par exemple la cellule de mémoire volatile 202. Par exemple, pendant une phase de sauvegarde de données, un bit de donnée est lu par le circuit de lecture/écriture 222 dans la cellule de mémoire volatile 202, et est écrit dans la cellule de mémoire non volatile 204. L'opération d'écriture implique l'application par le circuit de lecture/écriture 222 d'une tension haute sur la ligne de bit BL et d'une tension basse sur la ligne de bit BLB, ou vice versa, en fonction de la donnée à écrire. Le circuit de commande 224 active ensuite le signal WL2 pour activer le transistor 220, de sorte qu'un courant d'écriture circule dans une direction ou dans l'autre à travers l'élément résistif 218 pour programmer son état.

Le circuit de lecture/écriture 222 est aussi capable d'écrire un bit de donnée dans la cellule de mémoire volatile 202 par l'intermédiaire des lignes de bit BL et BLB. Ici encore, cette donnée peut être une donnée externe fournie au circuit de lecture/écriture 222, ou une donnée interne lue dans l'une des autres cellules mémoires, par exemple la cellule de mémoire non volatile 202. Par exemple, pendant une phase de restauration, un bit de donnée est lu par le circuit de lecture/écriture 222 dans la cellule de mémoire non volatile 204, et est écrit dans la cellule de mémoire volatile 202. L'opération d'écriture implique l'application par le circuit de lecture/écriture 222 d'une tension haute sur la ligne de bit BL et d'une tension basse sur la ligne de bit BLB, ou vice versa, en fonction de la donnée à écrire. Le circuit de commande 224 active ensuite le signal WL1, par exemple à un niveau bas, pour activer les transistors 214, 216, de sorte que la bascule formée par les inverseurs 206, 208 est programmée sur la base des tensions se trouvant sur les lignes de bit BL, BLB.

Bien que la figure 2 représente un exemple des circuits formant les cellules de mémoire volatile et non volatile 202, 204, il sera clair pour l'homme de l'art que dans des variantes de réalisation on pourrait utiliser des circuits différents.

La figure 3 illustre la cellule de mémoire non volatile 204 selon une variante de réalisation par rapport à celle représentée en figure 2. En particulier, plutôt que de comprendre un seul élément résistif 218, le circuit de la figure 3 comprend deux éléments résistifs 218A, 218B. L'élément 218A est couplé en série avec un transistor 220A, qui est par exemple un transistor PMOS, entre la ligne de bit BL et une tension d'alimentation intermédiaire V_{I}. De façon similaire, l'élément 218B est couplé en série avec un transistor 220B, qui est par exemple un transistor PMOS, entre la ligne de bit BLB et la tension d'alimentation intermédiaire V_{I}. Par exemple, les éléments résistifs 218A et 218B ont chacun l'un de leurs noeuds couplé à la tension V_{I}, et l'autre noeud couplé à la ligne de bit correspondante. Comme on va le décrire plus en détail ci-après, la tension d'alimentation intermédiaire V_{I} est par exemple égale à ou proche de la moitié de la valeur de la tension d'alimentation VDD. Les transistors 220A, 220B sont par exemple contrôlés par la ligne de sélection WL2.

Le bit de donnée non volatile représenté par les éléments résistifs 218A, 218B dépend duquel des éléments résistifs a la résistance Rₘₐₓ ou Rₘᵢₙ, en d'autres termes des résistances relatives. Les valeurs de Rₘₐₓ et de Rₘᵢₙ sont par exemple les mêmes que pour l'élément résistif 218 de la figure 2 décrit précédemment. En figure 3, l'élément résistif 218A est représenté programmé pour avoir une résistance Rₘᵢₙ et l'élément 218B une résistance Rₘₐₓ, et comme cela est représenté par les références Rₘₐₓ et Rₘᵢₙ entre parenthèses, la programmation opposée des valeurs de résistance serait possible.

En fonctionnement, le circuit de lecture/écriture 222 de la figure 2 écrit dans la cellule de mémoire non volatile 204 de la figure 3 de la même façon que cela a été décrit précédemment en relation avec la figure 2, en appliquant une tension haute à l'une des lignes de bit et une tension basse à l'autre ligne de bit, et en activant le signal WL2 pour provoquer le passage d'un courant dans chacun des éléments résistifs 218A, 218B. La tension haute étant par exemple à un niveau VDD compris entre 2 et 3 V, et la tension intermédiaire étant à environ VDD/2, par exemple entre 1 et 1,5 V, un courant va circuler dans chacun des éléments résistifs 218A, 218B dans une direction différente en fonction de la tension appliquée à la ligne de bit correspondante.

Le circuit de lecture/écriture 222 lit l'état résistif relatif des éléments résistifs 218A, 218B en appliquant une tension, par exemple la tension d'alimentation VDD ou la masse, à chacune des lignes de bit BL, BLB, pendant que le signal WL2 est activé, puis en comparant, en utilisant un comparateur, le niveau du courant circulant vers ou à partir de chaque ligne de bit.

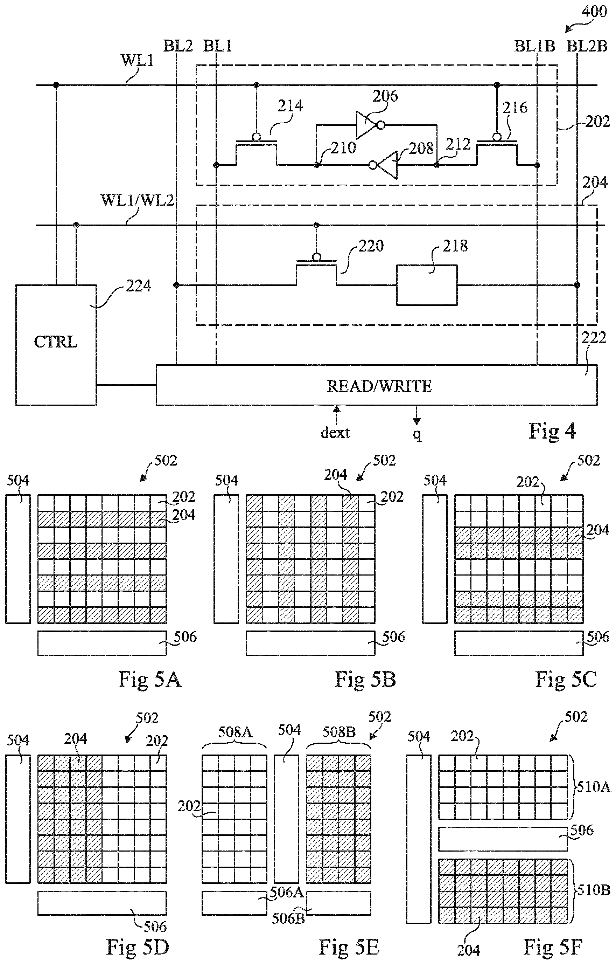

La figure 4 illustre schématiquement un circuit 400 associé à une colonne d'une matrice de mémoire non volatile/volatile selon un autre exemple de réalisation de la présente description. Le circuit 400 est très similaire à celui de la figure 2 et de mêmes éléments portent de mêmes références et ne vont pas être décrits de nouveau en détail. Toutefois, dans la figure 4, la cellule de mémoire volatile 202 est couplée entre une première paire de lignes de bit BL1, BL1B, et la cellule de mémoire non volatile 204 est couplée entre une deuxième paire de lignes de bit BL2, BLB2. Ainsi le circuit de lecture/écriture 222 accède à une donnée mémorisée par la cellule de mémoire volatile 202 par intermédiaire des lignes de bit BL1, BL1B, et à une donnée mémorisée par la cellule de mémoire non volatile 204 par l'intermédiaire des lignes de bit BL2, BL2B.

Les transistors 214, 216 de la cellule de mémoire volatile sont contrôlés par la ligne de sélection WL1, et le transistor 220 de la cellule de mémoire non volatile 204 peut être contrôlé par une ligne de sélection WL2 différente comme dans le circuit de la figure 2, ou par la même ligne de sélection WL1 que la cellule mémoire 202. Dans le dernier cas, l'opération de sauvegarde ou de restauration décrite précédemment entre les cellules de mémoire 202, 204 peut être réalisée en activant seulement le signal de commande WL1.

Bien que cela ne soit pas représenté en figure 4, il peut y avoir d'autres cellules de mémoire non volatile couplées entre les lignes de bit BL1, BL1B et d'autres cellules de mémoire non volatile associées couplées entre les lignes de bit BL2, BL2B. En outre, la cellule de mémoire non volatile 204 de la figure 4 pourrait en variante être mise en oeuvre par le circuit de la figure 3, les transistors 220A, 220B étant couplés aux lignes de bits BL2, BL2B.

Les figures 5A à 5F représentent schématiquement des agencements de cellules de mémoire volatile et non volatile dans des matrices mémoires 502 selon des exemples de réalisation de la présente description. Dans ces figures, les carrés vides représentent des cellules de mémoire volatile 202, et les carrés hachurés en diagonale représentent des cellules de mémoire non volatile 204. Un circuit de commande de rangées 504 génère les signaux de commande pour contrôler les lignes de sélection WL1, WL2 des cellules mémoire du réseau, et un bloc de lecture/écriture 506 lit et écrit dans les cellules mémoire du réseau. Pour faciliter l'illustration, les figures 5A à 5F illustrent des matrices mémoires 502 comprenant seulement 32 cellules de mémoire volatile 202 et 32 cellules de mémoire non volatile 204. Dans des variantes de réalisation, il pourrait y avoir un nombre quelconque de cellules de mémoire volatile et non volatile.

En figure 5A, la matrice mémoire 502 comprend des rangées alternées de cellules de mémoire volatile 202 et de cellules de mémoire non volatile 204. Chaque cellule de mémoire volatile 202 est par exemple adjacente verticalement à sa cellule de mémoire non volatile 204 associée. Dans chaque colonne, les cellules mémoires partagent une paire commune de lignes de bit, comme dans le mode de réalisation de la figure 2.

En figure 5B, la matrice mémoire 502 comprend des colonnes alternées de cellules de mémoire volatile 202 et de cellules de mémoire non volatile 204. Chaque cellule de mémoire volatile 202 est par exemple adjacente horizontalement à sa cellule de mémoire non volatile 204 associée. Ainsi, les cellules de mémoire volatile et non volatile ne partagent pas de paires de lignes de bits, ce mode réalisation étant similaire à celui de la figure 4. Aussi, comme dans le mode réalisation de la figure 4, les cellules de mémoire volatile et non volatile 202, 204 dans chaque rangée peuvent partager ou pas une ligne de sélection de rangée commune.

En figure 5C, la matrice mémoire 502 est similaire à celle de la figure 5A, comprenant des rangées de cellules de mémoire volatile 202, et des rangées de cellules de mémoire non volatile 204. Toutefois, plutôt qu'il y ait des rangées alternées de cellules de mémoire volatile et non volatile, les rangées de cellules de mémoire volatile 202 sont regroupées, et les rangées de cellules de mémoire non volatile 204 sont regroupées, chaque groupe comportant deux rangées dans l'exemple de la figure 5C. Ainsi chaque cellule de mémoire volatile 202 n'est plus adjacente à sa cellule de mémoire non volatile 204 associée.

En figure 5D, la matrice mémoire 502 est similaire à celle de la figure 5B, comprenant des colonnes de cellules de mémoire volatile 202 et des colonnes de cellules de mémoire non volatile 204. Toutefois, plutôt qu'il y ait des colonnes alternées de cellules de mémoire volatile et non volatile, les colonnes de cellules de mémoire volatile 202 sont regroupées, et les colonnes de cellules de mémoire non volatile 204 sont regroupées, chaque groupe comportant quatre colonnes dans l'exemple de la figure 5D. Ainsi, ici encore chaque cellule de mémoire volatile 202 n'est plus adjacente à sa cellule de mémoire non volatile 204 associée.

En figure 5E, la matrice mémoire 502 est similaire à la matrice de la figure 5D, excepté que les colonnes de cellules de mémoire volatile 202 forment un banc 508A de cellules mémoires, et les colonnes de cellules non volatiles 204 forment un autre banc 508B de cellules mémoire. Les bancs 508A, 508B sont par exemple séparés physiquement par le circuit de commande de rangées 504, et chaque rangée de cellules de mémoire volatile 202 du banc 508A peut partager ou pas une ligne de sélection de rangée commune avec une rangée correspondante de cellules de mémoire non volatile 204 du banc 508B. Chaque banc 508A, 508B est par exemple associé à un bloc de lecture/écriture correspondant 506A, 506B.

En figure 5F, la matrice mémoire 502 est similaire à la matrice de la figure 5C, excepté que les rangées de cellules de mémoire volatile 202 forment un banc 510A de cellules mémoires, et les rangées de cellules de mémoire non volatile 204 forment un autre banc 510B de cellules mémoires. Les bancs 510A, 510B sont par exemple physiquement séparés par le bloc de lecture/écriture 506. Par exemple, les colonnes de cellules de mémoire volatile 202 du banc 510A ne partagent pas de lignes de bit communes avec les colonnes de cellules de mémoire non volatile 204 du banc 510B.

La figure 6 illustre les cellules de mémoire volatile 202 plus en détail selon un exemple de réalisation. L'inverseur 206 est par exemple constitué d'un transistor PMOS 602 et d'un transistor NMOS 604 couplés en série entre un noeud d'alimentation 605 et la masse. Les noeuds de commande des transistors 602, 604 sont couplés au noeud de mémorisation 210, et un noeud intermédiaire entre ces transistors constitue le noeud de mémorisation 212. De façon similaire, l'inverseur 208 est par exemple constitué d'un transistor PMOS 606 et d'un transistor NMOS 608 couplés en série entre le noeud d'alimentation 605 et la masse. Les noeuds de commande des transistors 606, 608 sont couplés au noeud de mémorisation 212, et un noeud intermédiaire entre ces transistors constitue le noeud de mémorisation 210.

Le noeud d'alimentation 605 est par exemple couplé à un rail d'alimentation en tension 610, qui est à son tour couplé à une tension d'alimentation VDD par l'intermédiaire d'un transistor PMOS 612 contrôlé par un signal de sommeil SLEEP. Le rail d'alimentation 610 alimente par exemple toutes les cellules de mémoire volatile de la colonne, et ainsi en désactivant le transistor 612, les cellules de mémoire volatile peuvent avoir leur alimentation coupée pour économiser l'énergie. En particulier, avant de passer dans le mode de sommeil, les données provenant de chacune des cellules de mémoire volatile 202 sont par exemple sauvegardées dans leurs cellules de mémoire non volatile 204 associées, puis les cellules de mémoire volatile ont leur alimentation coupée en désactivant le transistor 612. À la fin de la période de sommeil, le transistor 612 est par exemple activé pour alimenter les cellules de mémoire volatile 202, et les données mémorisées par chacune des cellules de mémoire non volatile 204 sont par exemple restaurées dans leurs cellules de mémoire volatile associées.

La figure 7A illustre schématiquement un dispositif mémoire comprenant le circuit 200 de la figure 2 selon un exemple de réalisation. La façon dont ce dispositif pourrait être adapté pour fonctionner sur la base des cellules mémoires des figures 3 ou 4 apparaîtra clairement à l'homme de l'art.

Deux colonnes COL0 et COL1 sont illustrées en figure 7, et deux cellules de mémoire volatile 202 et deux cellules de mémoire non volatile 204 sont illustrées dans chaque colonne, bien que dans des variantes de réalisation il puisse y avoir un nombre quelconque de colonnes et un nombre quelconque de cellules mémoires dans chaque colonne.

Le circuit de lecture/écriture comprend un module de lecture/écriture 702, et un multiplexeur de colonne (Col Mux) 704 associé à chaque colonne. Ainsi, dans le mode de réalisation de la figure 7A, le module de lecture/écriture 702 est associé à plusieurs colonnes de la matrice mémoire. Dans des variantes de réalisation, un module de lecture/écriture 702 séparé pourrait être prévu pour chaque colonne de la matrice.

La figure 7B illustre plus en détail l'un des multiplexeurs de colonne 704 selon un exemple de réalisation. En référence aux deux figures 7A et 7B, le multiplexeur de colonne 704 de la colonne COL0 couple sélectivement les lignes de bit BL, BLB respectivement :
à des lignes d'écriture complémentaires wdl et nwdl lorsqu'un signal d'écriture wdec0 de la colonne COL0 est activé ;
à une tension d'alimentation VDD pour précharger les lignes de bit avant qu'une cellule volatile soit lue lorsqu'un signal de précharge blprechn est activé ;
à des lignes de lecture de cellule volatile complémentaires rsrdl, nrsrdl, lorsqu'un signal de lecture volatile rsrdec0 de la colonne COL0 est activé ; et
à une ligne de lecture non volatile rsttrdl et à un niveau de tension de lecture, par exemple la masse, lorsque le signal de lecture non volatile rsttdec0 est activé.

Le multiplexeur de colonne 704 comprend par exemple :
deux transistors PMOS contrôlés par le signal blprechn pour coupler respectivement les lignes de bit BL et BLB à la tension d'alimentation VDD ;
deux transistors NMOS contrôlés par le signal wdec pour coupler respectivement les lignes de bit BL et BLB aux lignes d'écriture wdl et nwdl ;
deux transistors NMOS contrôlés par le signal rsrdec pour coupler respectivement les lignes de bit BL et BLB aux lignes de lecture volatile rsrdl et nrsrdl ; et
deux transistors NMOS contrôlés par le signal rsttdec pour coupler respectivement les lignes de bit BL et BLB à la ligne de lecture non volatile rsttrdl et la masse.

En faisant de nouveau référence à la figure 7A, le module de lecture/écriture 702 comprend un circuit d'écriture 706, qui génère des tensions à appliquer aux lignes de bit d'une colonne sélectionnée sur la base d'un signal d'écriture wrt provenant du bloc de commande 224, et d'un signal de données d provenant d'un multiplexeur de données 708. Le multiplexeur de données 708 sélectionne soit la donnée dext externe reçue de l'extérieur de la matrice mémoire, soit la donnée dint interne lue dans la cellule mémoire de la matrice, sur la base d'un signal de sauvegarde/restauration svrte.

Le module de lecture/écriture 702 comprend aussi un comparateur (Comp) 710, ayant des entrées positive et négative respectivement couplées aux lignes de lecture de cellules volatile nrsrdl et rsrdl. Une sortie du comparateur 710 est couplée à une bascule de données (Latch) 712, qui à son tour fournit le signal de donnée interne dint. Le comparateur 710 et la bascule 712 reçoivent chacun un signal de synchronisation compe. Le signal de données interne dint est fourni par l'intermédiaire d'un tampon de sortie 713 sous forme du signal de données de sortie q du module de lecture/écriture 702.

La ligne de lecture de cellule non volatile rsttrdl est couplée à un circuit de bridage de tension (clamp) 714, qui applique un niveau de tension à la ligne rsttrdl afin de générer un courant dans l'élément résistif d'une cellule de mémoire non volatile 204 sélectionnée. De façon similaire, le circuit de bridage de tension 714 applique aussi par exemple une tension à une ligne référence refsttrdl couplée à un dispositif de référence (non illustré) de sorte qu'un courant de référence est généré. Le dispositif de référence a par exemple une résistance égale à (Rₘₐₓ+Rₘᵢₙ)/2, de sorte que le courant de référence fournit un niveau de coupure pour déterminer si l'élément résistif a une résistance programmée Rₘᵢₙ ou Rₘₐₓ. Les courants générés par le circuit de bridage de tension 714 sont convertis en niveaux de tension et amplifiés par un amplificateur 716. Le circuit de bridage de tension 714 et l'amplificateur 716 reçoivent par exemple un signal de synchronisation ampe.

L'amplificateur 716, fournit des sorties de tension différentielles, qui à leur tour sont couplées par l'intermédiaire de commutateurs 718 aux entrées du comparateur 710. Les commutateurs 718 sont contrôlés par un signal de commande de lecture non volatile rdstte provenant du bloc de commande 224.

Un décodeur de rangée 720 est par exemple associé à chaque paire de rangées volatile/non volatile de la matrice mémoire. Le décodeur de rangée 720 reçoit une adresse de rangée, et lorsque l'adresse correspond à l'adresse de la rangée, active le signal de commande de rangée WL1 correspondant lorsqu'un signal de sélection de rangée volatile wlsrame est activé, ou active le signal de commande de rangée WL2 correspondant lorsqu'un signal de sélection de rangée non volatile wlsttrame est activé.

Le bloc de commande 224 reçoit un signal d'horloge clk, un signal d'adresse de rangée Row Ad, un signal d'adresse de colonne Col Ad, un signal d'activation d'écriture we, un signal de sélection de cellule non volatile stte, un signal de sélection de cellule volatile sre, un signal de sauvegarde save, et un signal de restauration restore.

On va maintenant décrire le fonctionnement de la mémoire 700 en référence à la figure 8.

La figure 8 est un chronogramme illustrant des exemples des signaux clk, save, restore, blprechn, wlsrame, wlsttrame, rsrdec0, rsttdec0, wdec0, svrte, rdstte, ampe, compe, wrt, q, dint_stt and dint_sr, dans la matrice mémoire 700 de la figure 7A pendant une opération de sauvegarde et une opération de restauration entre les cellules de mémoire volatile et non volatile de la colonne COLO de la figure 7A. Le signal dint_stt correspond à la donnée mémorisée par la cellule de mémoire non volatile 204 et le signal dint_sr correspond à la donnée mémorisée par la cellule de mémoire volatile 202. Pendant les opérations de sauvegarde et de restauration, le signal svrte est haut, de sorte que les données écrites dans les cellules mémoires sont les données internes dint qui ont été lues dans les cellules mémoires.

L'opération de sauvegarde est déclenchée par une valeur haute du signal save, et commence par une opération de lecture de la donnée dint_sr mémorisée par la cellule de mémoire volatile. Le signal blprechn est initialement bas pour pré-charger les lignes de bit BL et BLB. Le signal blprechn passe ensuite à l'état haut, le signal wlsrame passe à l'état haut pour activer le signal WL1 et sélectionner la cellule de mémoire volatile, et rsrdec0 passe à l'état haut pour coupler les lignes de bit de la colonne COLO aux entrées du comparateur 710. Le signal de synchronisation compe passe ensuite à l'état haut pour mémoriser le signal de données dans la bascule 712. Sur le front descendant du signal compe, le signal q passe au signal de donnée de cellule volatile dint_sr.

L'opération de sauvegarde implique ensuite une opération d'écriture dans la cellule non volatile. Ainsi les signaux wlsttrame et wdec0 sont hauts, et le signal d'écriture wrt passe ensuite à l'état haut. Après un temps d'écriture t_{wnv}, le signal d'écriture wrt passe à l'état bas, et la donnée dint_stt mémorisée par la cellule de mémoire non volatile devient égale à la donnée volatile dint_sr.

L'opération de restauration est déclenchée par une valeur haute du signal de restauration, et commence par une opération de lecture de la donnée dint_stt, mémorisée par la cellule de mémoire non volatile. Le signal wlsttrame passe ensuite à l'état haut pour activer le signal WL2 et sélectionne la cellule de mémoire non volatile, et rsttdec0 passe à l'état haut pour coupler les lignes de bit à la masse et à la ligne de données de lecture rsttrdl. Le signal de synchronisation ampe passe ensuite l'état haut pour activer le bridage de tension 714 et l'amplificateur 716, et le signal de synchronisation compe passe ensuite à l'état haut pour mémoriser le signal de données dans la bascule 712. Sur le front descendant du signal compe, le signal q passe au signal de donnée de cellule non volatile dint_stt.

L'opération de restauration implique ensuite une opération d'écriture dans la cellule volatile. Ainsi les signaux wlsrame et wdec0 sont hauts et le signal d'écriture wrt passe aussi à l'état haut. Après un temps d'écriture t_{wv}, qui est par exemple plus court que le temps d'écriture t_{wnv} de la cellule non volatile, le signal d'écriture wrt passe à l'état bas, et la donnée dint_sr mémorisée par la cellule de mémoire non volatile devient égale à la donnée non volatile dint_stt.

Un avantage des modes de réalisation décrits ici est que, en prévoyant dans une même matrice mémoire des cellules de mémoire volatile et des cellules de mémoire non volatile associées aux cellules volatiles, les cellules volatiles assurent des temps d'accès rapides, et la matrice mémoire peut avoir une surface relativement faible. En particulier, un circuit commun de lecture et/ou écriture peut être prévu pour les cellules de mémoire volatile et non volatile, et ainsi chaque cellule mémoire peut être mise en oeuvre avec relativement peu de transistors et aucun amplificateur de détection.

Avec la description ainsi faite d'au moins un mode de réalisation illustratif, diverses altérations, modifications et améliorations apparaîtront facilement à l'homme de l'art.

Par exemple, il sera clair pour l'homme de l'art que la tension d'alimentation V_{DD} dans les divers modes de réalisation pourrait être à un niveau quelconque, par exemple entre 1 et 3 V, et plutôt que d'être à 0V, la tension de masse pourrait aussi être considérée comme une tension d'alimentation qui pourrait avoir un niveau quelconque comme un niveau négatif.

En outre il sera clair pour l'homme de l'art que, dans tous les modes de réalisation décrits ici, tous les transistors NMOS pourraient être remplacés par des transistors PMOS et/ou tous les transistors PMOS pourraient être remplacés par des transistors NMOS. La façon dont tous ces circuits pourraient être mis en oeuvre en utilisant seulement des transistors PMOS ou seulement des transistors NMOS apparaitra facilement à l'homme de l'art. En outre, bien qu'on ait décrit ici des transistors basés sur la technologie MOS, dans des variantes de réalisation on pourrait utiliser d'autres technologies de transistors, comme la technologie bipolaire.

En outre, il sera clair pour l'homme de l'art que les divers éléments décrits en relation avec les divers modes de réalisation pourraient être combinés, dans des variantes de réalisation, selon des combinaisons quelconques.

## Revendications

1. Matrice mémoire comprenant :
une pluralité de cellules de mémoire volatile (202) comprenant chacune une bascule (206, 208) ;
une pluralité de cellules de mémoire non volatile (204) comprenant chacune au moins un élément résistif (218, 218A, 218B) programmable par la direction d'un courant qu'on fait passer dans celui-ci pour prendre l'un d'au moins deux états résistifs (Rₘᵢₙ, Rₘₐₓ), chacune des cellules de mémoire non volatile étant associée à l'une correspondante des cellules de mémoire volatile ; **caractérisé par**
un circuit de lecture/écriture (222) couplé à chacune des cellules de mémoire volatile et non volatile par l'intermédiaire d'une ou plusieurs paires de lignes de bit (BL, BLB), le circuit de lecture/écriture comportant un comparateur (710) comportant des première et deuxième entrées, et adapté à lire un premier bit de donnée mémorisé par une première des cellules de mémoire volatile et à lire un deuxième bit de donnée mémorisé par une deuxième des cellules de mémoire non volatile, le circuit de lecture/écriture (222) comprenant en outre :
au moins un multiplexeur (704, 718) adapté à coupler les première et deuxième entrées du comparateur à des noeuds de mémorisation complémentaires (210, 212) de la première cellule de mémoire volatile pour lire le premier bit de donnée, et à coupler les première et deuxième entrées du comparateur à des sorties d'un amplificateur (716) adapté à détecter l'état résistif programmé de la deuxième cellule de mémoire non volatile.

2. Matrice mémoire selon la revendication 1, dans laquelle le circuit de lecture/écriture (222) est adapté à réaliser au moins l'une des opérations suivantes :
lire le premier bit de donnée mémorisé par une première des cellules de mémoire volatile et programmer, sur la base du premier bit de donnée, l'état résistif d'une première des cellules de mémoire non volatile associée à la première cellule de mémoire volatile ; et
lire, dans une deuxième des cellules de mémoire non volatile, un état résistif programmé représentant le deuxième bit de donnée et écrire le deuxième bit de donnée dans une deuxième des cellules de mémoire volatile associée à la deuxième cellule de mémoire non volatile.

3. Matrice mémoire selon l'une quelconque des revendications 1 ou 2, dans laquelle le circuit de lecture/écriture comprend en outre :
un circuit d'écriture (706) adapté à écrire un bit de donnée dans une première des cellules de mémoire volatile en appliquant une tension entre des noeuds de mémorisation complémentaires (210, 212) de la première cellule de mémoire volatile et à programmer un état résistif d'une première des cellules de mémoire non volatile en faisant passer un courant dans l'élément résistif (218, 218A, 218B) de la première cellule de mémoire non volatile.

4. Matrice mémoire selon l'une quelconque des revendications 1 à 3, comprenant en outre une pluralité de lignes de sélection (WL1), et dans laquelle :
chacune des cellules de mémoire volatile et sa cellule de mémoire non volatile associée est couplée à une même ligne de sélection (WL1) de la matrice mémoire.

5. Matrice mémoire selon l'une quelconque des revendications 1 à 4, dans laquelle chacune des cellules de mémoire volatile (202) et sa cellule de mémoire non volatile associée (204) sont couplées à une même paire de lignes de bit (BL, BLB).

6. Matrice mémoire selon l'une quelconque des revendications 1 à 5, dans laquelle chacune des cellules de mémoire volatile (202) est couplée à une première paire de lignes de bit (BL1, BL1B) et dans laquelle chacune des cellules de mémoire non volatile est couplée à une deuxième paire de lignes de bit (BL2, BL2B).

7. Matrice mémoire selon l'une quelconque des revendications 1 à 6, dans laquelle chacune des cellules de mémoire volatile (202) est couplée à un rail de tension d'alimentation (610) couplé par l'intermédiaire d'un commutateur (612) à un niveau de tension d'alimentation.

8. Matrice mémoire selon l'une quelconque des revendications 1 à 7, dans laquelle chacune des cellules de mémoire non volatile (204) comprend un seul élément résistif (218) couplé en série avec un premier transistor (220) entre une paire de lignes de bit (BL, BLB).

9. Matrice mémoire selon l'une quelconque des revendications 1 à 7, dans laquelle chacune des cellules de mémoire non volatile (204) comprend :
un premier élément résistif (218A) couplé en série avec un premier transistor (220A) entre une première ligne de bit (BL) et une première tension d'alimentation ; et
un deuxième élément résistif (218B) couplé en série avec un deuxième transistor (218B) entre une deuxième ligne de bit (BLB) et la première tension d'alimentation.

10. Matrice mémoire selon l'une quelconque des revendications 1 à 9, dans laquelle ledit au moins un élément résistif (218, 218A, 218B) de chacune des cellules de mémoire non volatile (204) est de l'un des types suivants :
un élément à couple de transfert de spin ayant une anisotropie dans le plan ;
un élément à couple de transfert de spin ayant une anisotropie perpendiculaire au plan ; et
un élément à oxydoréduction (RedOx).

11. Procédé de sauvegarde de données dans la matrice mémoire selon l'une quelconque des revendications 1 à 10, le procédé comprenant:
lire un premier bit de donnée mémorisé par une première des cellules de mémoire volatile ; et
programmer l'état résistif d'une première des cellules de mémoire non volatile associée à la première cellule de mémoire volatile sur la base du premier bit de données.

12. Procédé de restauration de données dans la matrice mémoire de l'une quelconque des revendications 1 à 10, le procédé comprenant :
lire dans une deuxième des cellules de mémoire non volatile un état résistif programmé représentant un deuxième bit de données ; et
écrire le deuxième bit de données dans une deuxième des cellules de mémoire volatile associée à la deuxième cellule de mémoire non volatile.

## Patentansprüche

1. Speicheranordnung, die Folgendes aufweist:
eine Vielzahl von flüchtigen Speicherzellen (202), die jeweils ein Latch (206, 208) aufweisen;
eine Vielzahl von nichtflüchtigen Speicherzellen (204), von denen jede wenigstens ein Widerstandselement (218, 218A, 218B) aufweist, das durch die Richtung des durch sie geleiteten Stroms programmierbar ist, um einen von wenigstens zwei Widerstandszuständen (Rₘᵢₙ, Rₘₐₓ) zu haben, wobei jede der nichtflüchtigen Speicherzellen mit einer entsprechenden der flüchtigen Speicherzellen assoziiert ist; **gekennzeichnet durch**
eine Lese-/Schreibschaltung (222), die über ein oder mehrere Paare von Bitleitungen (BL, BLB) mit jeder der flüchtigen und nichtflüchtigen Speicherzellen gekoppelt ist, wobei die Lese-/Schreibschaltung einen Komparator (710) mit ersten und zweiten Eingängen aufweist und zum Lesen eines ersten Datenbits, das von einer ersten der flüchtigen Speicherzellen gespeichert ist, und zum Lesen eines zweiten Datenbits, das von einer zweiten der nichtflüchtigen Speicherzellen gespeichert ist, geeignet ist, wobei die Lese-/Schreibschaltung (222) ferner Folgendes aufweist:
wenigstens einen Multiplexer (704, 718), der geeignet ist, um den ersten und zweiten Eingang des Komparators mit komplementären Speicherknoten (210, 212) der ersten flüchtigen Speicherzelle zu koppeln, um das erste Datenbit zu lesen, und um die ersten und zweiten Eingänge des Komparators mit Ausgängen eines Verstärkers (716) zu koppeln, der geeignet ist, um den programmierten Widerstandszustand der zweiten nichtflüchtigen Speicherzelle zu detektieren.

2. Speicheranordnung nach Anspruch 1, wobei die Lese-/Schreibschaltung (222) geeignet ist, um wenigstens eines der Folgenden durchzuführen:
Lesen des ersten Datenbits, das durch eine erste der flüchtigen Speicherzellen gespeichert ist, und basierend auf dem ersten Datenbit Programmieren des Widerstandszustands einer ersten der nichtflüchtigen Speicherzellen, die mit der ersten flüchtigen Speicherzelle assoziiert ist; und
Lesen eines programmierten Widerstandszustands, der das zweite Datenbit darstellt, aus einer zweiten der nichtflüchtigen Speicherzellen und Schreiben des zweiten Datenbits in eine zweite der flüchtigen Speicherzellen, die mit der zweiten nichtflüchtigen Speicherzelle assoziiert ist.

3. Speicheranordnung nach einem der Ansprüche 1 oder 2, wobei die Lese-/Schreibschaltung ferner Folgendes aufweist:
eine Schreibschaltung (706), die geeignet ist, um ein Datenbit in eine erste der flüchtigen Speicherzellen zu schreiben, indem eine Spannung an komplementäre Speicherknoten (210, 212) der ersten flüchtigen Speicherzelle angelegt wird, und um einen Widerstandszustand einer ersten der nichtflüchtigen Speicherzellen zu programmieren, indem ein Strom durch das Widerstandselement (218, 218A, 218B) der ersten nichtflüchtigen Speicherzelle geleitet wird.

4. Speicheranordnung nach einem der Ansprüche 1 bis 3, die ferner eine Vielzahl von Auswahlleitungen (WL1) aufweist und wobei:
jede der flüchtigen Speicherzellen und ihre assoziierte nichtflüchtige Speicherzelle mit einer gleichen Auswahlleitung (WL1) der Speicheranordnung gekoppelt sind.

5. Speicheranordnung nach einem der Ansprüche 1 bis 4, wobei jede der flüchtigen Speicherzellen (202) und ihre assoziierte nichtflüchtige Speicherzelle (204) jeweils mit einem gleichen Paar von Bitleitungen (BL, BLB) gekoppelt sind.

6. Speicheranordnung nach einem der Ansprüche 1 bis 5, wobei die flüchtigen Speicherzellen (202) jeweils mit einem ersten Paar von Bitleitungen (BL1, BL1B) gekoppelt sind und wobei die nichtflüchtigen Speicherzellen jeweils mit einem zweiten Paar von Bitleitungen (BL2, BL2B) gekoppelt sind.

7. Speicheranordnung nach einem der Ansprüche 1 bis 6, wobei jede der flüchtigen Speicherzellen (202) mit einer Spannungsversorgungsschiene (610) gekoppelt ist, die über einen Schalter (612) mit einem Versorgungsspannungspegel gekoppelt ist.

8. Speicheranordnung nach einem der Ansprüche 1 bis 7, wobei die nichtflüchtigen Speicherzellen (204) jeweils ein einzelnes Widerstandselement (218) aufweisen, das in Reihe mit einem ersten Transistor (220) zwischen einem Paar von Bitleitungen (BL, BLB) geschaltet ist.

9. Speicheranordnung nach einem der Ansprüche 1 bis 7, wobei die nichtflüchtigen Speicherzellen (204) jeweils Folgendes aufweisen:
ein erstes Widerstandselement (218A), das in Reihe mit einem ersten Transistor (220A) zwischen einer ersten Bitleitung (BL) und einer ersten Versorgungsspannung geschaltet ist; und
ein zweites Widerstandselement (218B), das in Reihe mit einem zweiten Transistor (218B) zwischen einer zweiten Bitleitung (BLB) und der ersten Versorgungsspannung geschaltet ist.

10. Speicheranordnung nach einem der Ansprüche 1 bis 9, wobei das wenigstens eine Widerstandselement (218, 218A, 218B) jeder der nichtflüchtigen Speicherzellen (204) eine der Folgenden ist:
ein Spin-Transfer-Torque-Element mit Anisotropie in der Ebene;
ein Spin-Transfer-Torque-Element mit senkrecht zur Ebene stehender Anisotropie; und
ein Reduktionsoxid (RedOx)-Element.

11. Verfahren zur Datensicherung in der Speicheranordnung nach einem der Ansprüche 1 bis 10, wobei das Verfahren Folgendes aufweist:
Lesen eines ersten Datenbits, das von einer ersten der flüchtigen Speicherzellen gespeichert ist; und
Programmieren des Widerstandszustands einer ersten der nichtflüchtigen Speicherzellen, die mit der ersten flüchtigen Speicherzelle assoziiert ist, basierend auf dem ersten Datenbit.

12. Verfahren zum Wiederherstellen von Daten in der Speicheranordnung nach einem der Ansprüche 1 bis 10, wobei das Verfahren Folgendes aufweist:
Lesen eines programmierten Widerstandszustands, der ein zweites Datenbit darstellt, aus einer zweiten der nichtflüchtigen Speicherzellen; und
Schreiben des zweiten Datenbits in eine zweite der flüchtigen Speicherzellen, die mit der zweiten nichtflüchtigen Speicherzelle assoziiert ist.

## Claims

1. A memory array comprising:
a plurality of volatile memory cells (202) each comprising a latch (206, 208);
a plurality of non-volatile memory cells (204) each comprising at least one resistive element (218, 218A, 218B) programmable by the direction of current passed through it to have one of at least two resistive states (Rₘᵢₙ, Rₘₐₓ), wherein each of the non-volatile memory cells is associated with a corresponding one of said volatile memory cells; **characterized by**
a read/write circuit (222) coupled to each of the volatile and non-volatile memory cells via one or more pairs of bit lines (BL, BLB), the read/write circuit having a comparator (710) having first and second inputs, and adapted to read a first data bit stored by a first of the volatile memory cells and to read a second data bit stored by a second of the non-volatile memory cells, the read/write circuit (222) further comprising:
at least one multiplexer (704, 718) adapted to couple the first and second inputs of the comparator to complementary storage nodes (210, 212) of said first volatile memory cell to read said first data bit, and to couple the first and second inputs of the comparator to outputs of an amplifier (716) adapted to detect the programmed resistive state of said second non-volatile memory cell.

2. The memory array of claim 1, wherein said read/write circuit (222) is adapted to perform at least one of:
read the first data bit stored by a first of said volatile memory cells and program, based on said first data bit, the resistive state of a first of said non-volatile memory cells, associated with said first volatile memory cell; and
read, from a second of said non-volatile memory cells, a programmed resistive state representing the second data bit and write said second data bit to a second of said volatile memory cells associated with said second non-volatile memory cell.

3. The memory array of any of claims 1 or 2, wherein said read/write circuit further comprises:
a write circuit (706) adapted to write a data bit to a first of said volatile memory cells by applying a voltage across complementary storage nodes (210, 212) of said first volatile memory cell and to program a resistive state of a first of said non-volatile memory cells by passing a current through the resistive element (218, 218A, 218B) of the first non-volatile memory cell.

4. The memory array of any of claims 1 to 3, further comprising a plurality of selection lines (WL1), and wherein:
each of said volatile memory cells and its associated non-volatile memory cell are coupled to a same selection line (WL1) of said memory array.

5. The memory array of any of claims 1 to 4, wherein each of said volatile memory cells (202) and its associated non-volatile memory cell (204) are each coupled to a same pair of bit lines (BL, BLB).

6. The memory array of any of claims 1 to 5, wherein said volatile memory cells (202) are each coupled to a first pair of bit lines (BL1, BL1B) and wherein said non-volatile memory cells are each coupled to a second pair of bit lines (BL2, BL2B).

7. The memory array of any of claims 1 to 6, wherein each of said volatile memory cells (202) is coupled to a voltage supply rail (610) coupled via a switch (612) to a supply voltage level.

8. The memory array of any of claims 1 to 7, wherein said non-volatile memory cells (204) each comprise a single resistive element (218) coupled in series with a first transistor (220) between a pair of bit lines (BL, BLB).

9. The memory array of any of claims 1 to 7, wherein said non-volatile memory cells (204) each comprise:
a first resistive element (218A) coupled in series with a first transistor (220A) between a first bit line (BL) and a first supply voltage; and
a second resistive element (218B) coupled in series with a second transistor (218B) between a second bit line (BLB) and said first supply voltage.

10. The memory array of any of claims 1 to 9, wherein said at least one resistive element (218, 218A, 218B) of each of said non-volatile memory cells (204) is one of:
a spin transfer torque element with in-plane anisotropy;
a spin transfer torque element with perpendicular-to-plane anisotropy; and
a reduction oxide (RedOx) element.

11. A method of data back-up in the memory array of any of claims 1 to 10, the method comprising:
reading a first data bit stored by a first of said volatile memory cells; and
programming the resistive state of a first of said non-volatile memory cells associated with said first volatile memory cell based on said first data bit.

12. A method of restoring data in the memory array of any of claims 1 to 10, the method comprising:
reading from a second of said non-volatile memory cells a programmed resistive state representing a second data bit; and
writing said second data bit to a second of said volatile memory cells associated with said second non-volatile memory cell.
